# EUROPEAN PATENT SPECIFICATION

(11) **EP 2 700 809 B1**
(45) Date of publication and mention of the grant of the patent: **20.10.2021**
(21) Application number: 12773846.6
(22) Date of filing: 17.04.2012
(51) Int. Cl.: F02P 19/02

(54) **ELECTRIFICATION CONTROL DEVICE FOR GLOW PLUG**
ELEKTRIFIZIERUNGSSTEUERUNGSVORRICHTUNG FÜR EINE ZÜNDKERZE
DISPOSITIF DE COMMANDE D'ÉLECTRIFICATION DE BOUGIE DE PRÉCHAUFFAGE

(30) Priority: 18.04.2011 JP 2011092481
(43) Date of publication of application: 26.02.2014
(73) Proprietor: NGK Spark Plug Co., Ltd., Nagoya-shi Aichi 467-8525 (JP)
(72) Inventor: KUMAZAWA, Shinji, Nagoya-shi Aichi 467-8525 (JP); SATO, Yoshikuni, Nagoya-shi Aichi 467-8525 (JP); TODA, Satoru, Nagoya-shi Aichi 467-8525 (JP); NAKANO, Hitoshi, Nagoya-shi Aichi 467-8525 (JP)
(74) Representative: Grünecker Patent- und Rechtsanwälte PartG mbB
(86) International application number: PCT/JP2012/002635
(87) International publication number: WO 2012/144191

(56) References cited:
- EP-A2- 2 128 429
- JP-A- S6 153 462
- JP-A- 61 053 462
- JP-A- S58 176 475
- JP-A- 2002 013 461
- JP-A- 2002 013 461
- JP-A- 2004 044 580
- JP-A- 2004 044 580
- JP-A- 2010 085 058
- JP-A- 2010 085 058
- JP-B- 63 053 389
- US-A- 4 500 775
- US-A- 4 552 102
- US-A- 4 858 576

## Description

### TECHNICAL FIELD

The present invention relates to an energization (electrification) control device for a glow plug which is used so as to assist startup or operation of a diesel engine.

### BACKGROUND ART

Conventionally, a glow plug including a heat generation resistor which generates heat upon energization has been used so as to assist startup of a diesel engine or to stably operate the diesel engine. Examples of conventionally performed energization for such a glow plug are pre-glow energization which is performed for pre-heating of an engine so as to assist startup of the engine, and energization which is performed in a wait state in order to maintain the preheat temperature (hereinafter also referred to as "temperature-maintaining energization"). Also, after startup of an engine, so-called after-glow energization is performed so as to stabilize combustion during operation of the engine. In order to perform energization suitable for such different situations, there is used an energization control device which controls electric power supplied from an external power supply such as a battery. Further, in order to perform more accurate energization control, there is also employed a configuration in which electricity supply harness wires from an energization control device are connected individually and directly to a plurality of glow plugs and different control operations are performed for the individual glow plugs (see, for example, Patent Document 1).

In recent years, not only energization control but also determination as to whether or not a glow plug can function properly; i.e., so-called OBD (On-Board-Diagnosis), are considered to be important. An energization control device is required to have, as one of functions for OBD, a function of determining whether or not wire breakage has occurred in a glow plug.

In particular, in the case of a multi-cylinder diesel engine which has four or six cylinders, even when wire breakage has occurred in one or two of the glow plugs provided for these cylinders; i.e., in glow plugs whose number is equal to or less than a half of the total number of the glow plugs, it is difficult for a controller (ECU) of a vehicle or a driver to detect or determine the failure of wire breakage. This is because, if no wire breakage has occurred in the remaining glow plugs, the engine is seen to operate normally at first sight. However, if the engine is operated in such a state, the amount of unburned gas within exhaust gas increases. Also, other problems, such as deterioration of startability of the engine, may occur.

A wire breakage detection method developed under such circumstances is known. For example, such a wire breakage detection method is proposed in Patent Document 2. Specifically, a conduction path between a semiconductor switch for switching turn on and off electricity and a glow plug is pulled up to a predetermined voltage (specifically, a voltage supplied from a battery), and wire breakage of the glow plug is detected on the basis of the voltage of the conduction path. Such a method can be readily realized even in the case where a plurality of glow plugs are mounted on a multi-cylinder engine if electricity supply harness wires from an energization control device are connected individually and directly to the glow plugs as described above.

### PRIOR ART DOCUMENTS

### PATENT DOCUMENTS

Patent Document 1: Japanese Patent Application Laid-Open (kokai) No. 2004-190659
Patent Document 2: Japanese Patent Application Laid-Open (kokai) No. H2-199274

US 4858576 shows a glow plug alternator control apparatus which senses the voltage and current through a glow plug of the engine. The apparatus determines the resistance of the glow plug and compares it to a preselected resistance. A resistance error signal is delivered in response to a difference between the compared signals. One embodiment of this apparatus monitors an open-circuit of the glow plug.

US 4500775 discloses a method for detecting an open circuit in a glow plug group. According to this method, an elapsed time in which the composite resistance of glow plugs connected in parallel reaches a predetermined resistance value after the start of feeding the glow plugs is compared with a predetermined time elapsed from the same start time point, and by utilizing the result of the comparison it detects an open circuit failure occurring in a minimum number of heating members connected in parallel.

JP 61053462 discloses a disconnection detecting method of a heating body. According to this method, disconnection detection is performed by storing a parallel composite resistance value for the whole number of glow plugs at the time of their first electrification, and by comparing this value with a composite resistance value measured at other times of the electrification of the glow plugs.

JP 58176475 shows a disconnection detecting device for preheating plugs. In this device the plurality of preheating plugs are divided into more than two groups having the same number of plugs, the compound resistance value of each group is detected periodically, and the compound resistances of each preceding group are held for comparison.

### SUMMARY OF THE INVENTION

Incidentally, in the case of diesel engines, such as an engine mounted on a vehicle or a general purpose engine mounted on an agricultural machine, a construction machine, or the like, for the purpose of common use of parts or simplification of structure, individual glow plugs for a plurality of cylinders are electrically connected in parallel to an energization control device through an electrode plate. In such a case, detection of wire breakage of the glow plugs is not easy.

In view of the forgoing, it is an objective of the present invention to provide for an energization control device to which a plurality of glow plugs are electrically connected in parallel which is able to detect wire breakage of the glow plugs connected thereto. This objective is achieved by the features as set forth in claim 1. Further advantageous embodiments of the present invention are set forth in the dependent claims.

Configuration 1. An energization control device for a glow plug of the present configuration is disposed between a power supply for supplying electric power to a plurality of glow plugs mounted on an engine and the glow plugs, and controls the energization of the glow plugs.

The energization control device comprises:
a glow plug connection portion to which the plurality of glow plugs are electrically connected in parallel;
a voltage obtaining section which obtains at least one of a voltage supplied from the power supply and a voltage output from the glow plug connection portion;
a current obtaining section which obtains a current output from the glow plug connection portion to the glow plugs;
an energization state determination section which determines the state of energization of the glow plugs;
a threshold value setting section which sets a threshold value used for wire breakage determination on the basis of the energization state determined by the energization state determination section;
a resistance obtaining section which obtains a combined resistance of the glow plugs connected to the glow plug connection portion on the basis of the voltage obtained by the voltage obtaining section and the current obtained by the current obtaining section; and
a wire breakage detection section which determines whether or not wire breakage has occurred in the glow plugs on the basis of the result of comparison between the threshold value and the combined resistance obtained in the energization state at the time when the threshold value was set.

Glow plugs to be mounted on each engine are specified by the specifications and model number of the glow plugs. Accordingly, when the glow plugs to be used are specified, the combined resistance of the glow plugs connected to the glow plug connection portion of the energization control device can be calculated and known in advance. Also, the glow plugs, which are mounted on the engine having a plurality of cylinders, are electrically connected in parallel. Therefore, if wire breakage occurs in the glow plugs, the combined resistance increases. Accordingly, this combined resistance is compared with a predetermined threshold value, and if the combined resistance exceeds the threshold value, it can be determined that wire breakage has occurred in one of the plurality of glow plugs.

The timing at which the threshold value is set and the wire breakage determination is performed is important. As described above, each glow plug has specifications such as resistance, which are specified by its model number. However, since glow plugs are industrial products, they have some variation (tolerance). Accordingly, merely setting the threshold on the basis of the resistance (the center value of the resistance) of each glow plug indicated on a specification sheet does not mach necessarily the real situation, and proper performance of wire breakage detection is difficult.

Also, although the combined resistance of the glow plugs used for wire breakage determination is obtained (calculated) from the voltage (value) applied to the glow plugs and the current (value) flowing therethrough, the output of the power supply (e.g., the amount of power generated by a battery or an alternator) changes. In addition, the resistance of a heat generation resistor which constitutes each glow plug changes, at a rate determined by the temperature coefficient of resistance of a material from which the heat generation resistor is formed, due to heat generation of the heat generation resistor itself and heat transmitted from the engine.

Also, the positive electrodes of the glow plugs connected to the glow plug connection portion are connected together through an electricity supply harness or an electrode plate, and the negative electrodes of the glow plugs are grounded through a cylinder head to which the glow plugs are fixed, an engine block, or the like. Therefore, the combined resistance of the glow plugs obtained by the energization control device includes these resistances (hereinafter collectively referred to "harness resistance" for convenience), and is not equal to the actual combined resistance of the plurality of glow plugs. In view of this as well, setting of the above-mentioned threshold value is considered to be important.

Therefore, the threshold value is set on the basis of the state of energization of the glow plugs, and the comparison between the combined resistance of the glow plugs and the threshold value is performed in the energization state in which the threshold value is set, to thereby determine whether or not wire breakage has occurred in the glow plugs. The threshold value is set in accordance with the state of energization of the glow plugs, for example, at the time of completion of pre-glow energization, after elapse of a predetermined period of time after start of temperature-maintaining energization, immediately before cranking at the time of startup of the engine, or during a relatively stable state during after-glow energization. By means of comparing the combined resistance of the glow plugs with the threshold value set in the above-described manner, wire breakage detection can be performed in consideration of the above-described variation. Notably, the glow plugs are energized in different energization states (for example, a pre-glow energization state, a temperature-maintaining energization state, etc.) in accordance with the values of engine parameters (e.g., the rotational speed of the engine, the temperature of cooling water, the amount of fuel injection, etc.) which affect the temperatures of the glow plugs.

Even in the case where the threshold value is set in the above-described manner, wire breakage determination cannot be performed accurately in some cases. Here, the engine is assumed to have four cylinders. In the case where wire breakage has occurred in one glow plug, the combined resistance of the glow plugs becomes 1.3 times. In the case where wire breakage has occurred in two glow plugs, the combined resistance of the glow plugs becomes 2 times. However, the resistance of each glow plug, which may change among glow plugs of different model numbers, is about 250 mΩ when the glow plug is cold, and becomes about 600 mΩ when the glow plug reaches the saturated temperature during use in a diesel engine. Meanwhile in general, the resistance of the above-mentioned harness, which changes in accordance with the type, configuration, etc. of the engine, is about 10 mΩ to 50 mΩ. Therefore, depending on to the above-described variation, the operation state of the engine, the energization state of the glow plugs, there arises a situation in which a change in the combined resistance of the glow plugs becomes excessively small as compared with the harness resistance, and it becomes difficult to set a proper threshold value which allows detection of wire breakage of one glow plug. In such a case, the threshold value is set under the assumption that wire breakages has occurred in a plurality of glow plugs, whose number is small enough so that wire breakage of the glow plugs does not affect emission or drivability. Thus, it becomes possible to determine at least that "wire breakage has occurred in a large number of glow plugs." For example, in the case of an engine having three cylinders, it becomes possible to determine that wire breakage has occurred when wire breakage has occurred in two of the three cylinders. In the case of an engine having four cylinders, it becomes possible to determine that wire breakage has occurred when wire breakage has occurred in three of the four cylinders. In the case of an engine having six cylinders, it becomes possible to determine that wire breakage has occurred when wire breakage has occurred in four of the six cylinders. In particular, in the case of a diesel engine having six or more cylinders, the cylinders are divided into groups each including three cylinders, and a conduction path is formed for each group. In such a case, the above-described wire breakage determination can be performed, while the glow plugs connected in parallel to each conduction path are considered to be the above-mentioned plurality of glow plugs mounted on the engine.

Configuration 2. An energization control device for a glow plug of the present configuration is characterized in that
the threshold value setting section sets the threshold value when the temperatures of the glow plugs become stable in each energization state; and
the resistance obtaining section obtains the combined resistance of the glow plugs when the temperatures of the glow plugs become stable in each energization state.

According to the above-described configuration 2, the threshold value is set and the combined resistance of the glow plugs is obtained in a state in which the temperatures of the glow plugs are stable. Therefore, the determination as to whether or not wire breakage has occurred in the glow plugs can be made accurately.

Configuration 3. An energization control device for a glow plug of the present configuration is characterized in that in the case where the energization state determination section determines that the energization state is after-glow energization, the threshold value setting section sets the threshold value when the engine is in an idle state, and the resistance obtaining section obtains the combined resistance of the glow plugs when the engine is in the idle state.

Since the engine is being operated during the after-glow energization, the environment around the glow plugs may change continuously and remarkably due to a change in the operating condition of the engine. Therefore, it is difficult to accurately determine whether or not wire breakage has occurred in the glow plugs, when the operating condition of the engine changes. In view of this, the above-described configuration 3 is employed. Specifically, in the case where the determination as to whether or not wire breakage has occurred in the glow plugs is made during the after-glow energization, the threshold value is set and the combined resistance of the glow plugs is obtained when the engine is in an idle state in which the environment around the glow plugs is relatively stable. Thus, the determination as to whether or not wire breakage has occurred in the glow plugs can be made accurately even during the after-glow energization.

Configuration 4. An energization control device for a glow plug of the present configuration is characterized in that
the threshold value setting section sets a plurality of threshold values corresponding to a plurality of different energization states; and
the wire breakage detection section determines whether or not wire breakage has occurred in the glow plugs on the basis of the result of comparison between the combined resistance obtained in each energization state and the corresponding threshold value.

According to the configuration 4, the determination as to whether or not wire breakage has occurred in the glow plugs is performed on the base of the result of comparison between the combined resistance obtained in each of a plurality of different energization states (e.g., at the time of the pre-glow energization and at the time of the after-glow energization) and the corresponding threshold value. Therefore, the determination as to whether or not wire breakage has occurred in the glow plugs can be made more accurately.

Although the above-described configurations 1 to 4 allow detection of a state in which wire breakage has occurred in a large number of glow plugs, there is a demand for detecting a state in which wire breakage has occurred in a smaller number of glow plugs. This can be realized by implementing the following configuration additionally or alternatively.

Configuration 5. An energization control device for a glow plug of the present configuration is disposed between a power supply for supplying electric power to a plurality of glow plugs mounted on an engine and the glow plugs, and controls the energization of the glow plugs.

The energization control device comprises:
a glow plug connection portion to which the plurality of glow plugs are electrically connected in parallel;
a voltage obtaining section which obtains at least one of a voltage supplied from the power supply and a voltage output from the glow plug connection portion;
a current obtaining section which obtains a current output from the glow plug connection portion to the glow plugs;
an energization state determination section which determines the state of energization of the glow plugs;
a storage section which operates, when the glow plugs are energized first time, so as to obtain a combined resistance of the glow plugs connected to the glow plug connection portion on the basis of the voltage obtained by the voltage obtaining section and the current obtained by the current obtaining section and to store the obtained combined resistance as a first-time resistance;
a resistance obtaining section which operates, when wire breakage determination is to be performed for the glow plugs, so as to obtain the combined resistance of the glow plugs connected to the glow plug connection portion on the basis of the voltage obtained by the voltage obtaining section and the current obtained by the current obtaining section; and
a wire breakage detection section which determines whether or not wire breakage has occurred in the glow plugs on the basis of the result of comparison between the first-time resistance and the combined resistance obtained in the same energization state as the energization state in which the first-time resistance was obtained.

In the present configuration 5, when the glow plugs mounted on a diesel engine is energized first time, the combined resistance of the glow plugs is obtained, and the determination as to whether or not wire breakage has occurred in the glow plugs is made while the obtained combined resistance is used as a reference. Notably, the term "first time" is used so as to encompass the case where the combined resistance of the glow plugs is obtained when a vehicle completed in a production line is caused to travel by itself for transportation thereof and the case where a manufacturer who produces the vehicle or a dealer who sells the vehicle arbitrary sets the first-time resistance. Namely, the first-time resistance may be re-obtained by a resetting operation. Accordingly, immediately after replacement of the glow plugs, the first-time resistance can be set again by performing the resetting operation.

As described above, the harness resistance depends on the type, configuration, etc. of the engine, and the harness resistance can be univocally determined for cases where the same engine configuration and the same glow plug attachment configuration are employed. Accordingly, the first-time resistance can be set by performing an experiment, analysis, or calculation in advance for each vehicle model. However, the combined resistance obtained in advance may differ from the combined resistance obtained through actual measurement performed after the glow plugs are attached to the engine. Such difference may be produced due to individual differences produced during manufacture of the engine, the state of connection with the terminal of the electricity supply harness, the contact resistance between the electrode plate or the like and the glow plugs. In view of the above, after the glow plugs are actually attached to the engine, the combined resistance of the glow plugs is obtained and stored before an ordinary engine operation is performed, and wire breakage determination is performed while the stored combined resistance is used as a reference, whereby wire breakage determination for the glow plugs can be performed in a state suitable for each engine.

The first-time resistance, which is actually measured and stored, will be described. As described above, the glow plugs are energized in different energization states such as pre-glow energization, temperature-maintaining energization, etc. When the energization state changes, the environment and state of each glow plug, including the temperature thereof, change. Accordingly, when the combined resistance of the glow plugs is compared with the first-time resistance (reference value), obtainment of the combined resistance of the glow plugs must be performed in the same state as the state in which the combined resistance was stored as the first-time resistance.

A description will be provided while a vehicle on which a diesel engine is mounted is taken as an example. The vehicle is manufactured in a production line, and a predetermined number (e.g. 4) of glow plugs are attached to the engine in that process. A common electricity supply part such as an electrode plate is connected to the glow plugs, whereby the glow plugs are electrically connected in parallel. An energization control device for the glow plugs is mounted in, for example, the engine compartment, and is connected to a battery. Also, a conduction path for supplying electricity to the glow plugs is formed.

The vehicle manufactured through such a process is caused to travel by itself to a predetermined parking area for shipment. At that time, pre-heating of the glow plugs (pre-glow energization) is performed so as to start the engine. The pre-glow energization is performed over a short period of time (about 2 sec) such that the temperatures of the glow plugs reach 1000°C. When the key switch is then turned to a start position, the engine starts cranking. Notably, in the case where the key switch is not turned to the start position immediately after the completion of the pre-glow energization, temperature-maintaining energization is performed for a predetermined period of time so as to enable the glow plugs to maintain the high-temperature state, to thereby enable the engine to start cranking immediately.

When the engine starts as a result of cranking, electricity is supplied to the glow plugs for a predetermined period of time so as to maintain heat generation (after-glow energization), to thereby improve the state and efficiency of combustion of fuel immediately after the startup of the engine, whereby exhaust gas is purified. When the vehicle is transported to a predetermined location (parking area), the key switch is turned off, whereby the engine is stopped. If a predetermined period of time has elapsed at that time, the after-glow energization is already completed. Therefore, when the engine is stopped, the after-glow energization is interrupted. As shown in the above-described example, the first-time energization of the glow plugs is performed through the above-described series of steps.

The first-time resistance is obtained in these steps. Examples of the preferred timing of obtaining the first-time resistance include a point in time at which the pre-glow energization is completed, a point in time after the temperature-maintaining energization is performed for a predetermined period of time (e.g. 5 sec), a point in time immediately before cranking is started, a point in time during the after-glow energization, and a point in time after the vehicle is stopped.

These timings have a common point that the electric power supplied to the glow plugs under the control corresponding to each state and the temperature of heat generation of the glow plugs as a result of supply of electric power are relatively stable. In the present configuration, since wire breakage determination for the glow plugs is performed with the first-time resistance used as a reference, it is preferred that the first-time resistance be a stable value whose fluctuation is minimum.

Since the engine is operating during the after-glow energization, the environment within each combustion chamber tends to become instable due to injection of fuel, intake of air and exhaust of gas, explosion of combustion gas, etc. Therefore, it is desirable to monitor these states, select a state suitable for obtaining the first-time resistance, and obtain the first-time resistance in the selected state. Meanwhile, at other points in time, basically, the vehicle and the engine are stopped. Accordingly, the environment surrounding each glow plug is relatively stable, and it can be said that the glow plug is in a state in which disturbances are small; namely, a state in which the same environment can be readily reproduced. Although the first-time resistance may be obtained in any state, when the first-time resistance is obtained, it is stored such that the state in which the first-time resistance was obtained can be identified or distinguished from other states (e.g., RF1, RF2, RF3, etc.).

When the wire breakage determination for the glow plugs is performed, the (current) combined resistance of the glow plugs obtained at the time of determination is compared with the above-mentioned first-time resistance. This comparison may be performed by simply comparing the magnitudes of the two values, or may be performed by calculating the difference between the two values and using the difference as an index for determination. However, this comparison is performed under the premise that the energization state in which the current combined resistance used for the comparison is obtained is the same energization state in which the first-time resistance, which is the reference for the comparison, was obtained. Namely, in the case where the first-time resistance serving as a reference is one obtained at the time of completion of the first-time pre-glow energization, the current combined resistance obtained at the time of completion of the pre-glow energization is used. Similarly, in the case where the first-time resistance obtained immediately before the start of cranking is used as a reference, the current combined resistance obtained immediately before the start of cranking is used as the current combined resistance to be compared with the first-time resistance.

As described above, the state (i.e., the energization state) in which the first-time resistance is obtained is the same as the state in which it is compared with the current combined resistance. Therefore, the comparison of the combined resistance of the glow plugs only with the first-time resistance can be readily performed without being affected by the variation of the combined resistance of the glow plugs due to disturbances. As described above, the combined resistance of the glow plugs which the energization control device obtains from the glow plug connection portion contains various variations and error components. However, according to the present configuration, the wire breakage determination for the glow plugs can be performed, while at least variations caused by individual differences, harness resistance, etc. are cancelled out. Since the above-mentioned variations and error components are not small, possibly, the above-described configuration can determine that wire breakage has occurred only when wire breakage has occurred in a large number of glow lugs (three or more glow plugs in the case where the engine has four cylinders). In contrast, according to the present configuration, it becomes possible to determine that wire breakage has occurred even when wire breakage has occurred in a fewer number of glow lugs, whereby more accurate detection can be performed.

Configuration 6. An energization control device for a glow plug of the present configuration is characterized in that
the storage section sets the first-time resistance when the temperatures of the glow plugs become stable in each energization state; and
the resistance obtaining section obtains the combined resistance of the glow plugs when the temperatures of the glow plugs become stable in each energization state.

According to the above-described configuration 6, the first-time resistance is set and the combined resistance of the glow plugs is obtained in a state in which the temperatures of the glow plugs are stable. Therefore, the determination as to whether or not wire breakage has occurred in the glow plugs can be made accurately.

Configuration 7. An energization control device for a glow plug of the present configuration is characterized in that in the case where the energization state determination section determines that the energization state is after-glow energization, the storage section sets the first-time resistance when the engine is in an idle state, and the resistance obtaining section obtains the combined resistance of the glow plugs when the engine is in the idle state.

Since the engine is being operated during the after-glow energization, the environment around the glow plugs may change continuously and remarkably due to a change in the operating condition of the engine. Therefore, it is difficult to accurately determine whether or not wire breakage has occurred in the glow plugs, when the operating condition of the engine changes. In view of this, the above-described configuration 7 is employed. Specifically, in the case where the determination as to whether or not wire breakage has occurred in the glow plugs is made during the after-glow energization, the first-time resistance is set and the combined resistance of the glow plugs is obtained when the engine is in an idle state in which the environment around the glow plugs is relatively stable. Thus, the determination as to whether or not wire breakage has occurred in the glow plugs can be made accurately even during the after-glow energization.

Configuration 8. An energization control device for a glow plug of the present configuration is characterized in that
the storage section sets a plurality of first-time resistances corresponding to a plurality of different energization states; and
the wire breakage detection section determines whether or not wire breakage has occurred in the glow plugs on the basis of the result of comparison between the combined resistance obtained in each energization state and the corresponding first-time resistance.

According to the configuration 8, the determination as to whether or not wire breakage has occurred in the glow plugs is performed on the base of the result of comparison between the combined resistance obtained in each of a plurality of different energization states (e.g., during the pre-glow energization and during the after-glow energization) and the corresponding first-time resistance. Therefore, the determination as to whether or not wire breakage has occurred in the glow plugs can be made more accurately.

Configuration 9. An energization control device for a glow plug of the present configuration is characterized in that in the case where the wire breakage detection section determines that wire breakage has occurred in the glow plugs when the state of energization of the glow plug is after-glow energization, when the engines is started next time, the wire breakage detection section determines whether or not wire breakage has occurred in the glow plugs when the state of energization of the glow plug is at least one of pre-glow energization and temperature-maintaining energization, and finally determines whether or not wire breakage has occurred in the glow plugs on the basis of the result of the determination.

During the after-glow energization, the environment around each glow plug is unlikely to become stable, and as a result, the accuracy of the result of wire breakage determination at that time tends to be lower as compared with other energization states. Meanwhile, at the time of the pre-glow energization or at the time of the temperature-maintaining energization, disturbances around each glow plug are small. Therefore, the accuracy of the result of wire breakage determination is relatively high. In view of this, the above-described configuration 9 is employed. Specifically, if the wire breakage detection section determines, during the after-glow energization, that wire breakage has occurred in the glow plugs, when the engine is started next time, at least one of the pre-glow energization and the temperature-maintaining energization is executed so as to energize the glow plugs, and the breakage detection section determines whether or not wire breakage has occurred in the glow plugs at that time. The breakage detection section finally determines whether or not wire breakage has occurred in the glow plugs on the basis of the result of that determination. Thus, the determination as to whether or not wire breakage has occurred in the glow plugs can be performed more accurately.

### EFFECTS OF THE INVENTION

According to the above-described configurations, an energization control device to which a plurality of glow plugs are electrically connected in parallel can detect wire breakage of the glow plugs connected thereto, which detection has been difficult heretofore.

### BRIEF DESCRIPTION OF THE DRAWINGS

[FIG. 1] (a) is a partially cutaway front view of a glow plug of the present embodiment, and (b) is an enlarged partial cross-sectional view of a forward end portion of the glow plug.
[FIG. 2] Block diagram schematically showing the configuration of an energization control device for the glow plug of the present embodiment.
[FIG. 3] Flowchart for describing the processing of determining wire breakage of the glow plugs according to the present Example 1.

### MODES FOR CARRYING OUT THE INVENTION

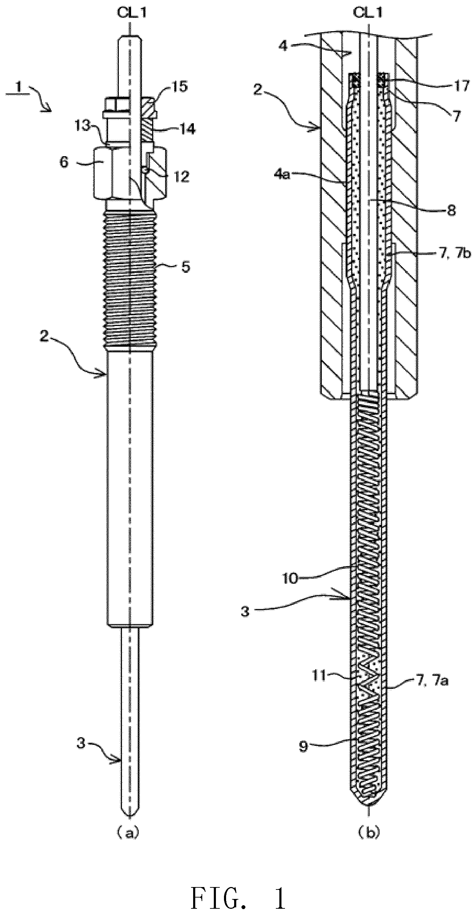

An embodiment of the present invention will now be described with referenced to the drawings. First, the structure of a glow plug 1 whose energization is controlled by an energization control device 30 for a glow plug of the present invention will be described. FIG. 1(a) is a partially cutaway front view showing an example of the glow plug, and FIG. 1(b) is a cross-sectional view of a forward end portion of the glow plug.

As shown in FIGS. 1(a) and 1(b), the glow plug 1 includes a tubular metallic shell 2, and a sheath heater 3 attached to the metallic shell 2.

The metallic shell 2 has an axial hole 4 which extends therethrough in the direction of an axis CL1. The metallic shell 2 has a thread portion 5 and a tool engagement portion 6 formed on the outer circumferential surface thereof. The thread portion 5 is used for attaching the glow plug 1 to a diesel engine. The tool engagement portion 6 has a hexagonal cross section, and a tool such as a torque wrench is engaged with the tool engagement portion 6.

The sheath heater 3 is constituted by uniting a tube 7 and a center rod 8 in the direction of the axis CL1.

The tube 7, which is closed at the forward end thereof, is a tube containing iron (Fe) or nickel (Ni) as a main component. The rear end of the tube 7 is sealed by an annular rubber member 17 disposed between the tube 7 and the center rod 8.

In addition, a heat generation coil 9 joined to the forward end of the tube 7 and a control coil 10 connected in series to the rear end of the heat generation coil 9 are enclosed in the tube 7, together with insulating powder 11 such as magnesium oxide (MgO) powder. Notably, although the heat generation coil 9 is electrically connected, at its forward end, to the tube 7, the outer circumferential surfaces of the heat generation coil 9 and the control coil 10 are insulated from the inner circumferential surface of the tube 7 because of the presence of the insulating powder 11.

The heat generation coil 9 is formed from a resistance heating wire formed of, for example, an Fe - chromium (Cr) - aluminum (Al) alloy. Meanwhile, the control coil 10 is formed from a resistance heating wire formed of a metallic material which is greater in the temperature coefficient of electrical resistivity than the material of the heat generation coil 9 (e.g., a metallic material which contains Co or Ni as a main component, such as cobalt (Co) - Ni - Fe alloy). Thus, the control coil 10 increases its electrical resistance upon receipt of heat from the heat generation coil 9 and the control coil 10 itself to thereby control the amount of electric power supplied to the heat generation coil 9 (so-called self-regulation function). Accordingly, at the beginning of energization, a relatively large amount of electric power is supplied to the heat generation coil 9, whereby the temperature of the heat generation coil 9 rises quickly. As a result, the control coil 10 is heated by the heat generation of the heat generation coil 9, and the electrical resistance of the control coil 10 increases, whereby the electric power supplied to the heat generation coil 9 decreases. As a result, the sheath heater 3 has a temperature rising characteristic in which after the quick temperature rise at the beginning of energization, the electric power supplied to the heat generation coil 9 is restrained by the action of the control coil 10, whereby the temperature becomes saturated. Namely, through provision of the control coil 10, excessive temperature rise (overshoot) of the heat generation coil 9 is suppressed, while the performance of quickly raising temperature is enhanced. Notably, the glow plug need not be a glow plug having the above-described self-regulation function, and no problem arises even when a material which is smaller in temperature coefficient than the above-described material (e.g., pure Ni or an Ni alloy containing a small amount of yttrium (Y)) may be properly selected as a material for the control coil 10.

The tube 7 has a small diameter portion 7a which is formed at the forward end thereof and which accommodates the heat generation coil 9, etc., and a large diameter portion 7b which is formed rearward of the small diameter portion 7a and which has a diameter greater than that of the small diameter portion 7a. The small diameter portion 7a and the large diameter portion 7b are formed by swaging or the like. This large diameter portion 7b is press-fitted into a small diameter portion 4a of the axial hole 4 of the metallic shell 2, whereby the tube 7 is held in a state in which it projects from the forward end of the metallic shell 2.

A forward end portion of the center rod 8 is inserted into the tube 7 and is electrically connected to the rear end of the control coil 10. The center rod 8 extends through the axial hole 4 of the metallic shell 2. The rear end of the center rod 8 projects from the rear end of the metallic shell 2. At the rear end of the metallic shell 2, an O-ring 12 formed of rubber or the like, an insulating bushing 13 formed of resin or the like, a press ring 14 for preventing coming off of the insulating bushing 13, and a nut 15 for connecting an electricity supply cable to the center rod 8 are fitted onto the center rod 8 in this order from the forward end side.

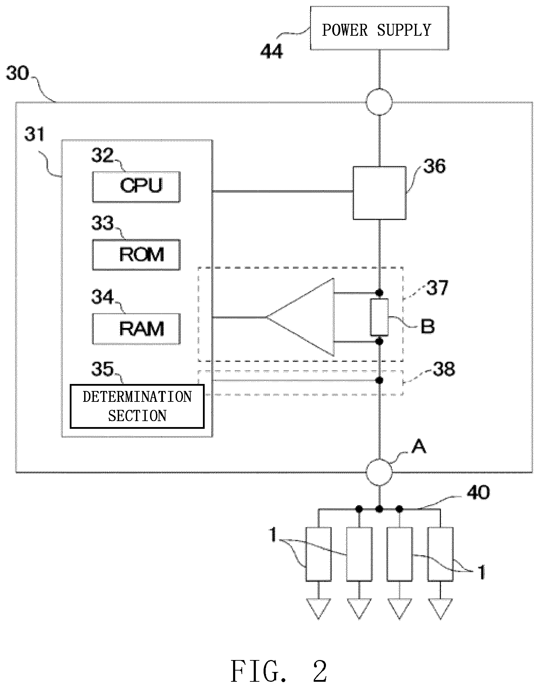

Next, an energization control device 30 for controlling energization of a plurality of glow plugs 1, which is the feature of the present invention, will be described with reference to FIG. 2. Notably, the plurality of glow plugs 1 are mounted on an internal combustion engine (not shown in the drawings), and are electrically connected to the earth (ground). The energization control device 30 receives an energization signal from an unillustrated external vehicle controller (ECU), etc., and controls the supply of electricity to the glow plugs 1.

The energization control device 30, which operates by using electrical power supplied from a power supply 44 composed of a battery, an alternator, etc., includes a microcomputer 31 including a CPU 32, ROM 33, RAM 34, etc. The energization control device 30 has an output terminal A, which serves as a glow plug connection portion for connection with the plurality of glow plugs 1. The plurality of glow plugs 1 are connected to this output terminal A through a conduction path 40 such as a conduction harness, an electrode plate, or the like.

The electric power supplied from the power supply 44 to the plurality of glow plugs 1 through the energization control device 30 passes through a switching section 36 for controlling the effective voltage supplied to the plurality of glow plugs 1, a current obtaining section 37 for obtaining the amount of current supplied to the glow plugs 1 (current value), and a voltage obtaining section 38 for obtaining the voltage of the output terminal A (output voltage).

The configurations of these sections will be described.

The switching section 36 receives the energization signal from the above-mentioned microcomputer 31, and controls, on the basis of this energization signal, the effective voltage of electric power supplied from the power supply 44 to the glow plugs 1. Although not illustrated, the switching section 36 includes an FET (field effect transistor) for ON/OFF control of energization, and a drive circuit which is composed of a plurality of resistors, a transistor, etc. and which drives the FET on the basis of the energization signal.

The current obtaining section 37 has a shunt resistor B provided, for example, between the switching section 36 and the output terminal A, and obtains the current supplied to the glow plugs 1 by measuring the current flowing through the shunt resistor B. Notably, the current obtaining section 37 may be realized by an FET having a current detection function which constitutes the switching section 36.

The voltage obtaining section 38 obtains the voltage applied to the glow plugs 1; i.e., the voltage at the glow plug connection portion A. The voltage obtaining section 38 may include unillustrated resistors for voltage division. Notably, when the above-mentioned current value and voltage value are obtained, unillustrated A/D converters which are provided within the microcomputer 31 or are provided separately are used.

Further, the energization control device 30 includes an energization state determination section 35. In the present embodiment, the energization state determination section 35 is also realized as one function of the microcomputer 31. Accordingly, whereas the energization control device 30 controls the energization of the glow plugs 1 on the basis of the energization signal received from the unillustrated ECU, the energization state determination section 35 determines whether the energization is pre-glow energization or after-glow energization. Also, the energization state determination section 35 receives information representing the rotational speed of the engine, information representing the temperature of cooling water, etc., and determines whether or not the state of the engine is stable.

Next, there will be described the control of energization of the glow plugs 1, which is performed by the energization control device 30. Since the method of controlling the energization of the glow plugs 1 (effective voltage control method) itself is the same as the known method, its description is omitted. Upon receipt of the energization signal from the ECU, etc., the microcomputer 31 outputs a signal for ON/OFF switching to the switching section 36 so as to perform duty control using a PWM control, to thereby control the supply of electric power to the glow plugs 1.

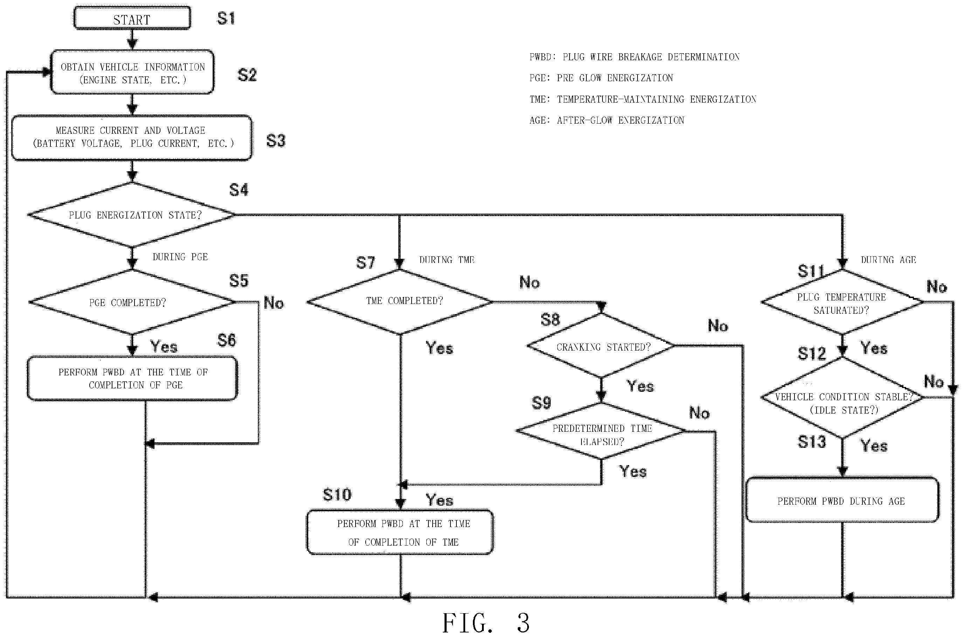

The energization control device 30 of the present invention determines whether or not wire breakage has occurred in the glow plugs 1, while controlling the supply of electric power to the glow plugs 1. Hereinafter, the method of detecting wire breakage will be described in detail with reference to FIG. 3.

### Example 1

The wire breakage detection in the present invention is performed independently of the supply of electric power to the glow plugs 1 for heat generation, although the state of electric power supply is referred to.

When an unillustrated key switch is turned from an OFF position to an ON position at the time of startup of the diesel engine, electric power is supplied to the energization control device 30, whereby the system of the device 30 starts (step S1). Notably, necessary initialization processing may be performed along with step S1. When the system starts, the energization control device 30 operates in accordance with an instruction (energization signal) from the ECU. In the case where the engine is in a cold state, for startup of the engine, the ECU outputs an energization signal to the energization control device 30. Upon receipt of this energization signal, the microcomputer 31 controls the ON/OFF state of the switching section 36 so as to enable the glow plugs 1 to quickly raise temperature for startup of the engine. In general, pre-glow energization (heating of the glow plugs 1 with the duty ratio set to 100%) is performed.

Meanwhile, in the processing for the wire breakage detection, the energization control device 30 obtains the state of the vehicle in step S2. In the present example, the energization control device 30 obtains, as vehicle information, the fact that the engine is in a state before being started; i.e., the engine is stopped.

Next, the energization control device 30 obtains the voltage and current of the electric power applied to the glow plugs 1. The energization control device 30 obtains the voltage from the voltage obtaining section 38 shown in FIG. 2, and the current from the current obtaining section 37 shown in FIG. 2 (step S3).

Further, the energization control device 30 determines the state of energization of the glow plugs 1 (step S4). Since pre-glow energization is currently performed, the energization control device 30 performs the processing for the period of pre-glow energization so as to perform wire breakage determination during the period of pre-glow energization (to step S5).

In step S5, the energization control device 30 determines whether or not the pre-glow energization is completed. The pre-glow energization is performed until the key switch is returned to the OFF position or the temperatures of the glow plugs 1 reach a temperature suitable for starting the engine. Accordingly, in the case where the temperatures of the glow plugs 1 have not increased sufficiently although the key switch is in the ON position, the energization control device 30 makes a "No" determination in step S5, and repeatedly performs steps S2 to S5 (waits) until the pre-glow energization is completed. Meanwhile, when the temperatures of the glow plugs 1 have increased sufficiently and the pre-glow energization is completed, the energization control device 30 makes a "Yes" determination in step S5, and proceeds to step S6.

In step S6, the energization control device 30 performs wire breakage determination for the glow plugs 1 at the time of completion of the pre-glow energization. The wire breakage determination at the time of completion of the pre-glow energization is performed through comparison between a threshold value which is used at the time of completion of the pre-glow energization and the combined resistance of the plurality of glow plugs 1 at the present. The combined resistance is calculated from the voltage and current obtained by the voltage obtaining section 38 and the current obtaining section 37, respectively. Setting of the threshold value and the comparison will be described later.

Next, wire breakage determination at the time of temperature-maintaining energization will be described. After completion of pre-heating by the pre-glow energization, the engine is cranked by a starter motor, whereby the engine is started. In the case where cranking is performed immediately after the completion of the pre-glow energization, heating of the glow plugs 1 is performed by after-glow energization. In some cases, cranking is not performed for a predetermined period of time after the completion of the pre-glow energization. In such a case, the state of energization of the glow plugs 1 is switched to temperature-maintaining energization for maintaining the glow plugs 1 at a temperature determined such that the engine can be started when cranking is started. Namely, in the case where the energization control device 30 determines in step S4 that the energization of the glow plugs 1 is the temperature-maintaining energization, the energization control device 30 proceeds to step S7 so as to perform the wire breakage determination processing for the temperature-maintaining energization.

First, the energization control device 30 determines in step S7 whether or not the temperature-maintaining energization is completed. As described above, the temperature-maintaining energization is performed so as to maintain the heating temperature at the time of completion of the pre-glow energization in the case where cranking is not started (namely, the key switch is not turned to the start position) after the key switch has been turned to the ON position. Accordingly, the temperature-maintaining energization over a long period of time may shorten the life of the glow plugs. Therefore, if cranking does not start even after performance of the temperature-maintaining energization over a period of time (e.g., 30 sec) which changes depending on the engine or the vehicle, the energization control device 30 performs a control of ending the temperature-maintaining energization, and entering a vehicle-stopped state which is similar to a state in which the key switch is in the OFF position. Through such a control, the energization control device 30 determines in step S7 whether or not the temperature-maintaining energization is completed. In the case where the energization control device 30 makes a "No" determination in step S7; i.e., determines that it waits the start of cranking, the energization control device 30 proceeds to step S8.

In step S8, the energization control device 30 determines whether or not cranking is started. When cranking is started (Yes in step S8), the engine starts to rotate, fuel is injected, and intake of air and exhaust of gas are started, whereby the ambient environment of the glow plugs 1 changes. Accordingly, large disturbances act on the glow plugs 1, and, in such a state, accurate determination of wire breakage is difficult. However, wire breakage determination can be performed at the time of cranking or a point in time immediately after the time of cranking (desirably, at a point in time immediately before cranking), because even if disturbances start, the influence of the disturbances on the temperatures of the glow plugs 1 is very small (or such influence does not exist). Meanwhile, in the case where cranking is not started (No in step S8), the energization control device 30 continuously waits for the start of cranking.

The energization control device 30 makes a further determination when it performs wire breakage determination upon making "Yes" determination in step S8; i.e., upon start of cranking. Namely, in step S9, the energization control device 30 determines whether or not the temperature-maintaining energization has been performed for a predetermined period of time (e.g., 5 sec). The temperature-maintaining energization is started immediately after the completion of the pre-glow energization. However, immediately after the start of the temperature-maintaining energization (within 5 sec in the present example), the influence of the pre-glow energization remains, and the state of the glow plugs 1 cannot be said to be stable. Since wire breakage determination cannot be performed accurately under such an environment, the energization control device 30 makes a "Yes" determination in step S9 only after elapse of a predetermined period of time, and proceeds to step S10 so as to determine whether or not wire breakage has occurred in the glow plugs. Meanwhile, in the case where the energization control device 30 determines that the predetermined period of time has not yet elapsed (No in step S9), the energization control device 30 determines that the chance of performing wire breakage determination during the temperature-maintaining energization is lost. Although not shown in the flowchart of FIG. 3, the energization control device 30 may set a flag to indicate that it failed to perform wire breakage determination during the temperature-maintaining energization, and subsequently perform a process of wire breakage determination during the after-glow energization. However, in the case where a process of the final determination on the wire breakage of the glow plugs is performed on the basis of the result of wire breakage determination performed during the pre-glow energization and the result of wire breakage determination performed during the after-glow energization which will be described later, needless to say, the content of the flag is also set properly.

Also, in the case where the energization control device 30 determines in the above-described step S7 that the temperature-maintaining energization is completed and enters the vehicle-stopped state, in step S10, the energization control device 30 performs wire breakage determination at the time of completion of the temperature-maintaining energization. At that time, the environment of the glow plugs 1 can be said to be most stable. This is because disturbances, such as fuel injection, intake of air and exhaust of gas, etc., do not exist, and energization is performed for a sufficiently long period of time, whereby the temperatures (resistances) of the glow plugs 1 are saturated.

The after-glow energization will be described before description of wire breakage determination at the time of the after-glow energization. The after-glow energization is energization which is performed after the engine is started. Therefore, unlike the pre-glow energization and the temperature-maintaining energization, its chance (the chance of the after-glow energization being performed) is obtained relatively easily because the engine is operating. If a driver quickly performs cranking at the time of the pre-glow energization or at the time of the temperature-maintaining energization, these energization processes are skipped. Meanwhile, the engine has already started its operation, and disturbances are relatively large. Therefore, it becomes difficult for the energization control device 30 to perform accurate determination as compared with the remaining two energization states. Therefore, it is desired to comprehensively perform wire breakage determination by combining the result of wire breakage determination at the time of the after-glow energization and the results of wire breakage determination at the time of other energization operations.

Next, there will be described wire breakage determination performed when the after-glow energization is performed after the engine has started. In the case where wire breakage determination is performed after the after-glow energization has been started, the energization control device 30 first determines whether or not the temperatures of the glow plugs 1 are saturated (step S11). This is because since the combined resistance of the glow plugs is unstable when the glow plugs 1 are not in a saturated state, it is difficult to perform determination through comparison between the combined resistance and a threshold value. Also, in order to perform accurate wire breakage determination, the energization control device 30 determines whether or not the engine in a stable state (step S12). The environment around the glow plugs 1 changes continuously and remarkably due to changes in the amount of fuel injected into the engine, the amount of inflow air, engine load, etc. If the glow plugs 1 receive the influence of the changes, it becomes difficult to accurately perform wire breakage determination. In view of this, the energization control device 30 determines whether or not the engine is in an operation state suitable for performing wire breakage determination. In particular, the energization control device 30 determines whether or not the engine is in an idle state.

In the case where the energization control device 30 determines in each of steps S11 and S12 that wire breakage determination can be performed (Yes in step S11, Yes in step S12), in step S13, the energization control device 30 performs wire breakage determination during the after-glow energization. Setting of the threshold value and the comparison will be described later.

Here, there will be described the threshold values which are used for the above-described wire breakage determination in each of the energization states.

The threshold value which is used for the wire breakage determination at the time of completion of the pre-glow energization is set as follows. The threshold value to be compared with the combined resistance of the glow plugs is determined in consideration of the fact that the resistances of the glow plugs are not saturated and are rising. In the above-described step S6, the combined resistance of the glow plugs is compared with this threshold value.

In consideration of the fact that the resistances of the glow plugs are saturated at the time of the after-glow energization, the threshold value to be compared with the combined resistance of the glow plugs is determined from the saturated resistances. In the above-described step S13, the combined resistance of the glow plugs is compared with this threshold value.

Further, during the temperature-maintaining energization, the resistances of the glow plugs have not yet become saturated, although the resistances are higher than those at the time of completion of the pre-glow energization. Therefore, it is preferred that the threshold value used for wire breakage determination be set to a value greater than the threshold value at the time of the pre-glow energization and less than the threshold value at the time of the after-glow energization. Namely, the threshold value used for the wire breakage determination performed during the temperature-maintaining energization is set to a value which is around the middle between the threshold value at the time of the pre-glow energization and the threshold value at the time of the after-glow energization.

The above-mentioned threshold values are set, and wire breakage determination is performed in each energization state. When the energization control device 30 finally determines that wire breakage has occurred, it reports the wire breakage to the ECU, etc. In such a case, the energization control device 30 may make such a report immediately after it determines that wire breakage has occurred in any of the above-mentioned energization states. Alternatively, the energization control device 30 may be configured to count the number of times which it determines that wire breakage has occurred (wire breakage count), and make such a report when the counted number reaches a predetermined count number. Alternatively, the energization control device 30 may be configured to make such a report only after it determines that wire breakage has occurred in all the energization states.

According to the above-described invention, it is possible to determine that wire breakage has occurred in a plurality of glow plugs even in the case where the plurality of glow plugs are electrically connected in parallel to the energization control device.

(a) For example, in the above-described Example 1, an absolute value is set as a threshold value used for wire breakage determination performed in each energization state, and is compared with the combined resistance of the glow plugs so as to determine whether or not wire breakage has occurred. However, a first-time resistance, which is the combined resistance of the glow plugs obtained during the first-time energization, may be used as the threshold value and be compared with the combined resistance of the glow plugs at the time of wire breakage determination so as to determine whether or not wire breakage has occurred. In this case, the combined resistance of the glow plugs (first-time resistance) is obtained and stored as a threshold value before ordinary engine operation is performed (e.g., when a vehicle completed in a production line is caused to travel by itself for transportation thereof), and, in each energization state, the wire breakage of the glow plugs is determined (detected) while the first-time resistance is used as a reference, as in the above-described Example 1.

(b) Also, the determination method of Example 1 in which an absolute value is used as a threshold value and the determination method which is described in the paragraph (a) and in which the initial value of the combined resistance is used as a threshold value may be performed simultaneously in parallel. By performing the two determination methods simultaneously, wire breakage determination can be performed in a manner more suitable to the situation. For example, in an ordinary state, a determination method which is small in processing load on the microcomputer is selectively performed, and when accurate wire breakage determination is required, the microcomputer moves to or calls the processing for accurate wire breakage determination.

(c) Wire breakage determination may be performed by weighting the results of wire breakage determination in each energization state and combining the weighted results. For example, as described above, during the after-glow energization, the environment around each glow plug 1 is unlikely to become stable, and as a result, the reliability of the result of the wire breakage determination at that time tends to become lower as compared with other energization states.

Meanwhile, the accuracy of the result of the wire breakage determination performed at the time of completion of the pre-glow energization or during the temperature-maintaining energization is relatively high because disturbances are small. However, the chance of performing such accurate wire breakage determination is lost if a driver starts cranking before completion of the pre-glow energization. Therefore, the chance of performing the accurate wire breakage determination is lost more easily as compared with the change of performing wire breakage determination during the after-glow energization. In order to overcome such a drawback, the following processing is performed. In an ordinary state, wire breakage determination is performed during the after-glow energization during which the chance of performing the wire breakage determination is easily obtained. In the case where occurrence of wire breakage is determined (detected), a signal for delaying the start of cranking is output to the ECU when the engine is started next time such that wire breakage determination is forcedly performed during the pre-glow energization and the temperature-maintaining energization. Thus, it becomes possible to detect wire breakage more accurately.

(d) Also, the result of wire breakage determination performed in each energization state may be weighted. For example, the wire breakage count is set to "1" when it is determined at the time of completion of the pre-glow energization that wire breakage has occurred, and set to "0.2" when it is determined during the after-glow energization that wire breakage has occurred. When the cumulative total of the wire breakage counts become equal to 1 or greater, it is determined that wire breakage has occurred in the glow plugs. Thus, wire breakage can be detected accurately.

(e) Although having described in connection with the after-glow energization, it is preferred that the combined resistance of the glow plugs be obtained after the resistances of the glow plugs become saturated. Accordingly, when wire breakage determination was able to be performed on the basis of the saturated resistances, the result of that determination may be employed preferentially over the results of the wire breakage determinations in other energization states. Of course, the results of the wire breakage determinations may be combined for comprehensive determination.

(f) In the above-described example, the glow plugs for which wire breakage determination is performed are so-called metal glow plugs each having a coil-shaped heat generation portion. However, the glow plugs for which wire breakage determination is performed are not limited thereto, and may be so-called ceramic glow plugs. Of course, the number of the glow plugs is not limited to four (four cylinders) employed in the above-described example, and wire breakage determination may be performed for an engine having six cylinders or eight cylinders and glow plugs mounted thereon. In the case where the type or number of glow plugs for which wire breakage determination is performed differs from that of the glow plugs in the above-described example, the threshold values are set to values suitable for the glow plugs for which wire breakage determination is to be performed, whereby the present invention can be properly applied.

### DESCRIPTION OF REFERENCE NUMERALS

1 ··· glow plug; 30 ··· energization control device; 31 ··· microcomputer: 35 ··· (failure) determination section; 37 ··· current obtaining section; 38 ··· voltage obtaining section; 40 ··· conduction path; 44 ··· power supply

## Claims

1. An energization control device (30) for a glow plug (1) adapted to be connected between a power supply (44) for supplying electric power to a plurality of glow plugs (1) mounted on an engine and the glow plugs (1) and adapted to control the energization of the glow plugs (1), comprising:
a glow plug connection portion (A) to which the plurality of glow plugs (1) are electrically connected in parallel;
a voltage obtaining section (38) adapted to obtain at least one of a voltage supplied from the power supply (44) and a voltage output from the glow plug connection portion (A);
a current obtaining section (37) adapted to obtain a current output from the glow plug connection portion (A) to the glow plugs (1);
an energization state determination section (35) adapted to determine the state of energization of the glow plugs (1);
a threshold value setting section adapted to set a threshold value used for wire breakage determination, wherein the threshold value is set for a specific energization state determined by the energization state determination section (35);
a resistance obtaining section adapted to obtain a combined resistance of the glow plugs (1) connected to the glow plug connection portion (A) on the basis of the voltage obtained by the voltage obtaining section (38) and the current obtained by the current obtaining section (37); and
a wire breakage detection section adapted to determine whether or not wire breakage has occurred in the glow plugs (1) on the basis of the result of comparison between the threshold value set for the specific energization state and the combined resistance obtained in the specific energization state for which the used threshold value was set,
**characterized in that**
in the case where the energization state determination section (35) determines that the energization state is after-glow energization, the threshold value setting section is adapted to set the threshold value for after-glow energization when the engine is in an idle state, and the resistance obtaining section is adapted to obtain the combined resistance of the glow plugs (1) when the engine is in the idle state.

2. The energization control device (30) for a glow plug (1) according to claim 1, wherein the specific energization state is any of pre-glow energization, temperature-maintaining energization, and after-glow energization.

3. The energization control device (30) for a glow plug (1) according to claim 1 or 2, wherein the threshold value setting section is adapted to set the threshold value for a specific energization state when the temperatures of the glow plugs (1) become stable in the respective energization state; and
the resistance obtaining section is adapted to obtain the combined resistance of the glow plugs (1) when the temperatures of the glow plugs (1) become stable in the respective energization state.

4. The energization control device (30) for a glow plug (1) according to any one of claims 1 to 3, wherein the threshold value setting section is adapted to set a plurality of threshold values corresponding to a plurality of different energization states; and
the wire breakage detection section is adapted to determine whether or not wire breakage has occurred in the glow plugs (1) on the basis of the result of comparison between the combined resistance obtained in each energization state and the corresponding threshold value.

5. The energization control device (30) for a glow plug (1) according to claim 1 or 2, further comprising a storage section which is adapted to operate, when the glow plugs (1) are energized first time, so as to obtain a combined resistance of the glow plugs (1) connected to the glow plug connection portion (A) on the basis of the voltage obtained by the voltage obtaining section (38) and the current obtained by the current obtaining section (37) and to store the obtained combined resistance as a first-time resistance,
wherein the threshold value setting section is adapted to set the first-time resistance as threshold value for the energization state in which the first-time resistance was obtained.

6. An energization control device (30) for a glow plug (1) according to claim 5, wherein the storage section is adapted to set the first-time resistance when the temperatures of the glow plugs (1) become stable in the respective energization state; and
the resistance obtaining section is adapted to obtain the combined resistance of the glow plugs (1) when the temperatures of the glow plugs (1) become stable in the respective energization state.

7. An energization control device (30) for a glow plug (1) according to claim 5 or 6, wherein in the case where the energization state determination section (35) determines that the energization state is after-glow energization, the storage section is adapted to set the first-time resistance when the engine is in an idle state, and the resistance obtaining section is adapted to obtain the combined resistance of the glow plugs (1) when the engine is in the idle state.

8. An energization control device (30) for a glow plug (1) according to any one of claims 5 to 7, wherein the storage section is adapted to set a plurality of first-time resistances corresponding to a plurality of different energization states; and
the wire breakage detection section is adapted to determine whether or not wire breakage has occurred in the glow plugs (1) on the basis of the result of comparison between the combined resistance obtained in each energization state and the corresponding first-time resistance.

9. An energization control device (30) for a glow plug (1) according to any one of claims 4 to 8, wherein in the case where the wire breakage detection section determines that wire breakage has occurred in the glow plugs (1) when the state of energization of the glow plug (1) is after-glow energization, when the engines is started next time, the wire breakage detection section is adapted to determine whether or not wire breakage has occurred in the glow plugs (1) when the state of energization of the glow plug (1) is at least one of pre-glow energization and temperature-maintaining energization, and finally determines whether or not wire breakage has occurred in the glow plugs (1) on the basis of the result of the determination.

## Patentansprüche

1. Erregungs-Steuerungsvorrichtung (30) für eine Glühkerze (1), die so eingerichtet ist, dass sie zwischen eine Energiequelle (44) zum Zuführen elektrischer Energie zu einer an einem Motor installierten Vielzahl von Glühkerzen (1) und die Glühkerzen (1) geschaltet ist, und die zum Steuern der Erregung der Glühkerzen (1) eingerichtet ist, wobei sie umfasst:
einen Glühkerzen-Verbindungsabschnitt (A), mit dem die Vielzahl von Glühkerzen (1) elektrisch parallel verbunden sind;
einen Teilabschnitt (38) zum Ermitteln einer Spannung, der so eingerichtet ist, dass er eine von der Energiequelle (44) zugeführte Spannung und/oder eine von dem Glühkerzen-Anschlussabschnitt (A) ausgegebene Spannung erfasst;
einen Teilabschnitt (37) zum Ermitteln eines Stroms, der zum Ermitteln eines von dem Glühkerzen-Anschlussabschnitt (A) an die Glühkerzen (1) ausgegebenen Stroms eingerichtet ist;
einen Teilabschnitt (35) für Bestimmung des Erregungszustandes, der zum Bestimmen des Erregungszustandes der Glühkerzen (1) eingerichtet ist;
einen Teilabschnitt zum Festlegen eines Schwellenwertes, der zum Festlegen eines Schwellenwertes eingerichtet ist, der für Feststellung von Drahtbruch dient, wobei der Schwellenwert für einen durch den Teilabschnitt (35) für Bestimmung des Erregungszustandes bestimmten spezifischen Erregungszustand festgelegt wird;
einen Teilabschnitt zum Ermitteln eines Widerstandes, der so eingerichtet ist, dass er einen kombinierten Widerstand der mit dem Glühkerzen-Verbindungsabschnitt (A) verbundenen Glühkerzen (1) auf Basis der durch den Teilabschnitt (38) zum Ermitteln einer Spannung ermittelten Spannung und des durch den Teilabschnitt (37) zum Ermitteln eines Stroms ermittelten Stroms ermittelt; und
einen Teilabschnitt für Erfassung von Drahtbruch, der so eingerichtet ist, dass er auf Basis des Ergebnisses von Vergleich zwischen dem für den spezifischen Erregungszustand festgelegten Schwellenwert und dem kombinierten Widerstand, der in dem spezifischen Erregungszustand ermittelt wurde, für den der verwendete Schwellenwert festgelegt wurde, feststellt, ob Drahtbruch in den Glühkerzen (1) aufgetreten ist,
**dadurch gekennzeichnet, dass**
der Teilabschnitt zum Festlegen eines Schwellenwertes so eingerichtet ist, dass er, wenn der Teilabschnitt (35) für Bestimmung des Erregungszustandes bestimmt, dass der Erregungszustand Nachglüh-Erregung ist, den Schwellenwert für Nachglüh-Erregung festlegt, wenn sich der Motor in einem Leerlaufzustand befindet, und der Teilabschnitt zum Ermitteln eines Widerstandes so eingerichtet ist, dass er den kombinierten Widerstand der Glühkerzen (1) ermittelt, wenn sich der Motor in dem Leerlaufzustand befindet.

2. Erregungs-Steuerungsvorrichtung (30) für eine Glühkerze (1) nach Anspruch 1, wobei der spezifische Erregungszustand Vorglüh-Erregung, Temperaturerhaltungs-Erregung oder Nachglüh-Erregung ist.

3. Erregungs-Steuerungsvorrichtung (30) für eine Glühkerze (1) nach Anspruch 1 oder 2, wobei der Teilabschnitt zum Festlegen eines Schwellenwertes so eingerichtet ist, dass er den Schwellenwert für einen spezifischen Erregungszustand festlegt, wenn die Temperaturen der Glühkerzen (1) in dem jeweiligen Erregungszustand stabil werden; und
der Teilabschnitt zum Ermitteln eines Widerstandes so eingerichtet ist, dass er den kombinierten Widerstand der Glühkerzen (1) ermittelt, wenn die Temperaturen der Glühkerzen (1) in dem jeweiligen Erregungszustand stabil werden.

4. Erregungs-Steuerungsvorrichtung (30) für eine Glühkerze (1) nach einem der Ansprüche 1 bis 3, wobei der Teilabschnitt zum Festlegen eines Schwellenwertes so eingerichtet ist, dass er eine Vielzahl von Schwellenwerten festlegt, die einer Vielzahl unterschiedlicher Erregungszustände entsprechen; und
der Teilabschnitt für Erfassung von Drahtbruch so eingerichtet ist, dass er auf Basis des Ergebnisses von Vergleich zwischen dem in jedem Erregungszustand ermittelten kombinierten Widerstand und dem entsprechenden Schwellenwert feststellt, ob Drahtbruch in den Glühkerzen (1) aufgetreten ist.

5. Erregungs-Steuerungsvorrichtung (30) für eine Glühkerze (1) nach Anspruch 1 oder 2, die des Weiteren einen Speicherungs-Teilabschnitt umfasst, der so eingerichtet ist, dass er so arbeitet, dass er, wenn die Glühkerzen (1) erstmalig erregt werden, einen kombinierten Widerstand der mit dem Glühkerzen-Verbindungsabschnitt (A) verbundenen Glühkerzen (1) auf Basis der von dem Teilabschnitt (38) zum Ermitteln einer Spannung ermittelten Spannung und des von dem Teilabschnitt (37) zum Ermitteln eines Stroms ermittelten Stroms ermittelt und den ermittelten kombinierten Widerstand als einen erstmaligen Widerstand speichert,
wobei der Teilabschnitt zum Festlegen eines Schwellenwertes so eingerichtet ist, dass er den erstmaligen Widerstand als Schwellenwert für den Erregungszustand festlegt, in dem der erstmalige Widerstand ermittelt wurde.

6. Erregungs-Steuerungsvorrichtung (30) für eine Glühkerze (1) nach Anspruch 5, wobei der Speicherungs-Teilabschnitt so eingerichtet ist, dass er den erstmaligen Widerstand festlegt, wenn die Temperaturen der Glühkerzen (1) in dem jeweiligen Erregungszustand stabil werden; und
der Teilabschnitt zum Ermitteln eines Widerstandes so eingerichtet ist, dass er den kombinierten Widerstand der Glühkerzen (1) ermittelt, wenn die Temperaturen der Glühkerzen (1) in dem jeweiligen Erregungszustand stabil werden.

7. Erregungs-Steuerungsvorrichtung (30) für eine Glühkerze (1) nach Anspruch 5 oder 6, wobei der Speicherungs-Teilabschnitt so eingerichtet ist, dass er, wenn der Teilabschnitt (35) für Bestimmung des Erregungszustandes bestimmt, dass der Erregungszustand Nachglüh-Erregung ist, den erstmaligen Widerstand festlegt, wenn sich der Motor in einem Leerlaufzustand befindet, und der Teilabschnitt zum Ermitteln eines Widerstandes so eingerichtet ist, dass er den kombinierten Widerstand der Glühkerzen (1) ermittelt, wenn sich der Motor in dem Leerlaufzustand befindet.

8. Erregungs-Steuerungsvorrichtung (30) für eine Glühkerze (1) nach einem der Ansprüche 5 bis 7, wobei der Speicherungs-Teilabschnitt so eingerichtet ist, dass er eine Vielzahl erstmaliger Widerstände festlegt, die einer Vielzahl unterschiedlicher Erregungszustände entsprechen; und der Teilabschnitt für Erfassung von Drahtbruch so eingerichtet ist, dass er auf Basis des Ergebnisses von Vergleich zwischen dem in jedem Erregungszustand ermittelten kombinierten Widerstand und dem entsprechenden erstmaligen Widerstand feststellt, ob Drahtbruch in den Glühkerzen (1) aufgetreten ist.

9. Erregungs-Steuerungsvorrichtung (30) für eine Glühkerze (1) nach einem der Ansprüche 4 bis 8, wobei der Teilabschnitt für Erfassung von Drahtbruch so eingerichtet ist, dass er, wenn der Teilabschnitt für Erfassung von Drahtbruch feststellt, dass Drahtbruch in den Glühkerzen (1) aufgetreten ist und der Erregungszustand der Glühkerze (1) Nachglüh-Erregung ist, wenn der Motor das nächste Mal gestartet wird, feststellt, ob Drahtbruch in den Glühkerzen (1) aufgetreten ist, wenn der Erregungszustand der Glühkerze (1) Vorglüh-Erregung oder/und Temperaturerhaltungs-Erregung ist, und abschließend auf Basis des Ergebnisses der Feststellung feststellt, ob Drahtbruch in den Glühkerzen (1) aufgetreten ist.

## Revendications

1. Dispositif de commande de mise sous tension (30) pour une bougie de préchauffage (1) adapté pour être connecté entre une alimentation en énergie (44) pour alimenter en énergie électrique une pluralité de bougies de préchauffage (1) montées sur un moteur et les bougies de préchauffage (1) et adapté pour commander la mise sous tension des bougies de préchauffage (1), comprenant :
une partie de connexion de bougies de préchauffage (A) à laquelle la pluralité de bougies de préchauffage (1) sont connectées électriquement en parallèle ;
une section d'obtention de tension (38) adaptée pour obtenir au moins l'une d'une tension alimentée par l'alimentation en énergie (44) et d'une sortie de tension provenant de la partie de connexion de bougies de préchauffage (A) ;
une section d'obtention de courant (37) adaptée pour obtenir une sortie de courant allant de la partie de connexion de bougies de préchauffage (A) aux bougies de préchauffage (1) ;
une section de détermination d'état de mise sous tension (35) adaptée pour déterminer l'état de mise sous tension des bougies de préchauffage (1) ;
une section d'établissement de valeur de seuil adaptée pour établir une valeur de seuil utilisée pour une détermination de rupture de fil, dans lequel la valeur de seuil est établie pour un état de mise sous tension spécifique déterminé par la section de détermination d'état de mise sous tension (35) ;
une section d'obtention de résistance adaptée pour obtenir une résistance combinée des bougies de préchauffage (1) connectées à la partie de connexion de bougies de préchauffage (A) sur la base de la tension obtenue par la section d'obtention de tension (38) et du courant obtenu par la section d'obtention de courant (37) ; et
une section de détection de rupture de fil adaptée pour déterminer si une rupture de fil s'est produite ou non dans les bougies de préchauffage (1) sur la base du résultat de comparaison entre la valeur de seuil établie pour l'état de mise sous tension spécifique et la résistance combinée obtenue dans l'état de mise sous tension spécifique pour lequel la valeur de seuil utilisée a été établie,
**caractérisé en ce que**
dans le cas où la section de détermination d'état de mise sous tension (35) détermine que l'état de mise sous tension est une mise sous tension post-préchauffage, la section d'établissement de valeur de seuil est adaptée pour établir la valeur de seuil pour une mise sous tension post-préchauffage lorsque le moteur est dans un état au ralenti, et
la section d'obtention de résistance est adaptée pour obtenir la résistance combinée des bougies de préchauffage (1) lorsque le moteur est dans l'état au ralenti.

2. Dispositif de commande de mise sous tension (30) pour une bougie de préchauffage (1) selon la revendication 1, dans lequel l'état de mise sous tension spécifique est l'une quelconque parmi une mise sous tension de pré-préchauffage, une mise sous tension de maintien de températures, et une mise sous tension post-préchauffage.

3. Dispositif de commande de mise sous tension (30) pour une bougie de préchauffage (1) selon la revendication 1 ou 2, dans lequel la section d'établissement de valeur de seuil est adaptée pour établir la valeur de seuil pour un état de mise sous tension spécifique lorsque les températures des bougies de préchauffage (1) deviennent stables dans l'état de mise sous tension respectif ; et
la section d'obtention de résistance est adaptée pour obtenir la résistance combinée des bougies de préchauffage (1) lorsque les températures des bougies de préchauffage (1) deviennent stables dans l'état de mise sous tension respectif.

4. Dispositif de commande de mise sous tension (30) pour une bougie de préchauffage (1) selon l'une quelconque des revendications 1 à 3, dans lequel la section d'établissement de valeur de seuil est adaptée pour établir une pluralité de valeurs de seuil correspondant à une pluralité d'états de mise sous tension différents ; et
la section de détection de rupture de fil est adaptée pour déterminer si une rupture de fil s'est produite ou non dans les bougies de préchauffage (1) sur la base du résultat de comparaison entre la résistance combinée obtenue dans chaque état de mise sous tension et la valeur de seuil correspondante.

5. Dispositif de commande de mise sous tension (30) pour une bougie de préchauffage (1) selon la revendication 1 ou 2, comprenant en outre une section de stockage qui est adaptée pour fonctionner, lorsque les bougies de préchauffage (1) sont mises sous tension pour la première fois, de manière à obtenir une résistance combinée des bougies de préchauffage (1) connectées à la partie de connexion de bougies de préchauffage (A) sur la base de la tension obtenue par la section d'obtention de tension (38) et du courant obtenu par la section d'obtention de courant (37) et stocker la résistance combinée obtenue en tant que résistance de première fois,
dans lequel la section d'établissement de valeur de seuil est adaptée pour établir la résistance de première fois comme valeur de seuil pour l'état de mise sous tension dans lequel la résistance de première fois a été obtenue.

6. Dispositif de commande de mise sous tension (30) pour une bougie de préchauffage (1) selon la revendication 5, dans lequel la section de stockage est adaptée pour établir la résistance de première fois lorsque les températures des bougies de préchauffage (1) deviennent stables dans l'état de mise sous tension respectif ; et
la section d'obtention de résistance est adaptée pour obtenir la résistance combinée des bougies de préchauffage (1) lorsque les températures des bougies de préchauffage (1) deviennent stables dans l'état de mise sous tension respectif.

7. Dispositif de commande de mise sous tension (30) pour une bougie de préchauffage (1) selon la revendication 5 ou 6, dans lequel, dans le cas où la section de détermination d'état de mise sous tension (35) détermine que l'état de mise sous tension est une mise sous tension post-préchauffage, la section de stockage est adaptée pour établir la résistance de première fois lorsque le moteur est dans un état au ralenti, et la section d'obtention de résistance est adaptée pour obtenir la résistance combinée des bougies de préchauffage (1) lorsque le moteur est dans l'état au ralenti.

8. Dispositif de commande de mise sous tension (30) pour une bougie de préchauffage (1) selon l'une quelconque des revendications 5 à 7, dans lequel la section de stockage est adaptée pour établir une pluralité de résistances de première fois correspondant à une pluralité d'états de mise sous tension différents ; et
la section de détection de rupture de fil est adaptée pour déterminer si une rupture de fil s'est produite ou non dans les bougies de préchauffage (1) sur la base du résultat de comparaison entre la résistance combinée obtenue dans chaque état de mise sous tension et la résistance de première fois correspondante.

9. Dispositif de commande de mise sous tension (30) pour une bougie de préchauffage (1) selon l'une quelconque des revendications 4 à 8, dans lequel, dans le cas où la section de détection de rupture de fil détermine qu'une rupture de fil s'est produite dans les bougies de préchauffage (1) lorsque l'état de mise sous tension de la bougie de préchauffage (1) est une mise sous tension post-préchauffage, lorsque le moteur est démarré une fois suivante, la section de détection de rupture de fil est adaptée pour déterminer si une rupture de fil s'est produite ou non dans les bougies de préchauffage (1) lorsque l'état de mise sous tension de la bougie de préchauffage (1) est au moins l'une parmi une mise sous tension pré-préchauffage et une mise sous tension de maintien de températures, et détermine en fin de compte si une rupture de fil s'est produite ou non dans les bougies de préchauffage (1) sur la base du résultat de la détermination.
